# EUROPEAN PATENT APPLICATION

(11) **EP 4 723 843 A2**
(43) Date of publication of application: **08.04.2026**
(21) Application number: 26158242.3
(22) Date of filing: 12.02.2026
(51) Int. Cl.: H10F 77/20

(54) **SOLAR CELL AND PHOTOVOLTAIC MODULE**

(30) Priority: 04.12.2025 CN 202511813887; 04.12.2025 CN 202522575197 U
(71) Applicant: Jinko Solar (Haining) Co., Ltd., Haining City, Zhejiang 314415 (CN)
(72) Inventor: BI, Shuqin, Haining, 314415 (CN); PENG, Yingying, Haining, 314415 (CN)
(74) Representative: Haseltine Lake Kempner LLP

(57) **Abstract**

A solar cell includes: a cell base including a plurality of first regions arranged along a first direction, at least one of the plurality of first regions being a target region; a plurality of fingers spaced apart along a second direction; and a plurality of solder joint structures connected to one of the plurality of fingers, the plurality of solder joint structures being provided in the target region and arranged along the second direction, the plurality of solder joint structures including a first solder joint, the first solder joint including a middle portion and edge portions being provided at both ends of the middle portion along the first direction, and a size of the middle portion along the second direction being less than a size of the edge portion along the second direction.

## Description

### TECHNICAL FIELD

The present application relates to the technical field of solar cells, and in particular to a solar cell and a photovoltaic module.

### BACKGROUND

In the manufacturing process of photovoltaic assemblies, a plurality of cells are connected to form a cell string using solder strips, and then laminated, framed, and other related processes are performed to form a photovoltaic module. The reliability of the connection between the solder strip and the corresponding cell affects the reliability of the photovoltaic module. Therefore, the reliability of the connection between the solder strip and the corresponding cell needs to be further improved.

### SUMMARY

According to various embodiments, a solar cell and a photovoltaic module are provided.

According to one aspect of the present application, a solar cell is provided, including a cell base, a plurality of fingers, and a plurality of solder joint structures. The cell base defines a plurality of first regions arranged along a first direction, and at least one of the plurality of first regions is a target region. The plurality of fingers are spaced apart along the second direction. The plurality of solder joint structures are connected to one of the plurality of fingers. The plurality of solder joint structures are located in the target area and arranged along the second direction. The plurality of solder joint structures include a first solder joint. The first solder joint includes a middle portion and edge portions provided at both ends of the middle portion along the first direction. A size of the middle portion along the second direction being less than a size of the edge portion along the second direction.

According to another aspect of the present application, a photovoltaic module is further provided, including the solar cell in any of the above embodiments and a solder strip, the solder strip is connected to a plurality of solder joint structures and covers at least part of the plurality of solder joint structure.

### BRIEF DESCRIPTION OF THE DRAWINGS

FIG. 1 is a schematic view of a solar cell according to some embodiments.
FIG. 2 is a schematic view of solder joint structures in the same target region.
FIG. 3 is a schematic view of a first solder joint.
FIG. 4 is a schematic view of solder joint structures in the same target region.
FIG. 5 is a schematic view of solder joint structures in the same target region.
FIG. 6 is a schematic view of a solar cell according to other embodiments.
FIG. 7 is a schematic view of solder joint structures in the same target region.
FIG. 8 is a schematic view of solder joint structures in the same target region.
FIG. 9 is a schematic view of solder joint structures in the same target region.
FIG. 10 is a schematic view of solder joint structures in the same target region.
FIG. 11 is a schematic view of solder joint structures in the same target region.
FIG. 12 is a schematic view of solder joint structures in the same target region.
FIG. 13 is a schematic view of a second solder joint.
FIG. 14 is a schematic view of a third solder joint.
FIG. 15 is a schematic view of a portion of a finger.
FIG. 16 is a schematic view of solder joint structures in the same target region.
FIG. 17 is a schematic view of solder joint structures in the same target region.
FIG. 18 is a schematic view of a solar cell.
FIG. 19 is a schematic view of solder joint structures in the same target region.
FIG. 20 is a schematic view of solder joint structures in the same target region.
FIG. 21 is a schematic view of a solar cell.
FIG. 22 is a schematic view of a partial structure of a solar cell.
FIG. 23 is a schematic view of a photovoltaic module.

### DETAILED DESCRIPTION OF THE EMBODIMENTS

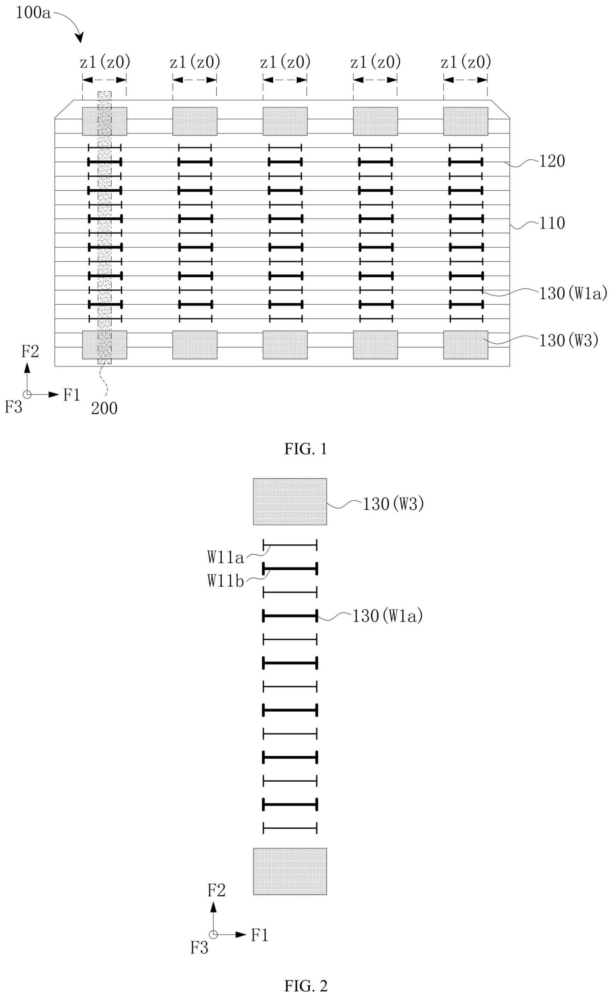

Referring to FIG. 1, which is a schematic view of a solar cell 100a according to some embodiments of the present application. The solar cell 100a includes a cell base 110, a plurality of fingers 120, and a plurality of solder joint structures 130.

The cell base 110 is a basic structure for realizing the photovoltaic effect. The cell base 110 can be configured as needed to obtain the required type of solar cell 100a. For example, the solar cell 100a may be a TOPCon (Tunnel Oxide Passivating Contacts) cell, a BC (Back Contact) cell, an HJT (Heterojunction with Intrinsic Thin-layer) cell, a perovskite cell, or a tandem cell, etc. The tandem cell may be a perovskite cell stacked with a TOPCon cell, a BC cell or an HJT cell, which is not limited herein. The solar cell 100a can be a whole cell, a half cell, or even a smaller cell, which is not limited herein. In addition, the cell base 110 refers to a prefabricated composite product containing a plurality of functional structures, rather than a single conventional silicon wafer.

Referring to FIG. 1, the cell base 110 defines a plurality of first regions z1 arranged along a first direction F1. In this embodiment, the first region z1 is a region configured to arrange a solder strip 200, thus the first region z1 can be understood as a welding region of the cell base 110. FIG. 1 illustrates the first region z1 and a boundary of the first region z1, and the solder strip 200 is provided on one first region z1, but it is not limited thereto, and the number of the first regions z1 is not specifically limited.

The finger 120 is a conductive structure printed on a surface of the cell base 110, which can collect separated charge carriers in the cell base 110. The solder joint structure 130 is a conductive structure located in the first region z1 and connected to the finger 120, and can form a metallurgical bond with the solder strip 200 through a welding process. In this way, the charge carriers collected by the finger 120 can be converged to the solder strip 200 through the solder joint structure 130. Referring to FIG. 1, the plurality of fingers 120 are spaced apart along a second direction F2, and the plurality of solder joint structures 130 arranged along the first direction F1 are connected to one finger 120.

Exemplarily, each finger 120 extends along the first direction F1, and the first direction F1 and the second direction F2 intersect.

Exemplarily, a thickness direction of the cell base 110 is parallel to a third direction F3, and the first direction F1, the second direction F2, and the third direction F3 are perpendicular to each other. The finger 120 can be provided on a front side and a back side of the cell base 110, or only on the back side of the cell base 110. The front side and the back side of the cell base 110 are opposite to each other along the third direction F3.

Referring to FIG. 1 and in conjunction with FIG. 2, which is a schematic view of the solder joint structures 130 in the same target region z0 according to some embodiments of the present application. At least one of the plurality of first regions z1 is defined as a target region z0. A plurality of solder joint structures 130 arranged along the second direction F2 are provided in the target region z0. In the same target region z0, the plurality of solder joint structures 130 include a first solder joint W1a.

Exemplarily, FIGS. 1 and 2 show that part of the solder joint structures 130 in the same target region z0 are configured as the first solder joints W1a. Alternatively, all the solder joint structures 130 in the same target region z0 may be configured as the first solder joints W1a, which is not specifically limited herein.

The target region z0 refers to one first region z1 of the plurality of first regions z1 in which the first solder joint W1a is provided. The target region z0 is not a new structure independent of the first region z1, but a functional region of the first region z1 whose functions differ from those of non-target regions. Exemplarily, FIG. 1 illustrates a case where all the first regions z1 are target regions z0. Alternatively, one first region z1 is configured as the target region z0, or part of the first regions z1 are configured as the target region z0, which is not specifically limited herein.

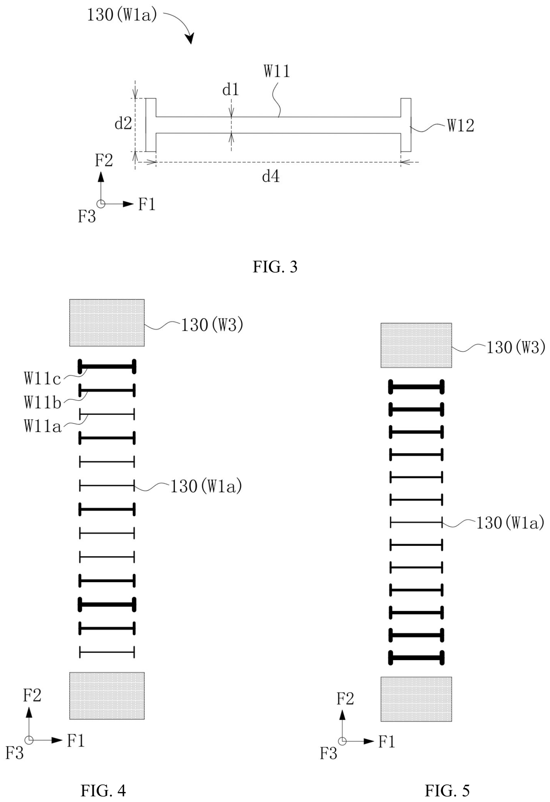

Referring to FIG. 2 and in conjunction with FIG. 3, which is a schematic view of the first solder joint W1a according to some embodiments of the present application. The first solder joint W1a includes a middle portion W11 and two edge portions W12. The two edge portions W12 are provided at both ends of the middle portion W11 along the first direction F1, and the size of the middle portion W11 along the second direction F2 is less than the size of the edge portion W12 along the second direction F2. Taking FIG. 3 as an example, the size of the middle portion W11 along the second direction F2 is defined as a first size d1, the size of the edge portions W12 along the second direction F2 is defined as a second size d2, and d1 < d2.

Exemplarily, the shape of the first solder joint W1a may be dumbbell-shaped, hourglass-shaped, double trapezoidal or H-shaped, which is not specifically limited herein. The dumbbell shape generally refers to a shape where the middle portion W11 is a straight section and the edge portions W12 are wide ends in circular, elliptical, etc. shape. The hourglass shape generally refers to a shape where the middle portion W11 is linearly narrowed and the edge portions W12 are wide ends in circular, elliptical, etc. shape. The double trapezoidal shape generally refers to a shape where the middle portion W11 is a straight section and the edge portions W12 are wide ends in trapezoidal shape. The H-shape generally refers to a shape where the middle portion W11 is a straight section and the edge portions W12 are rectangular strips. For example, taking FIGS. 1 to 3 as examples, the shape of the first solder joint W1a can be roughly regarded as an H-shape. Alternatively, the shape of the first solder joint W1a in the same target region z0 may not be at least one of the aforementioned dumbbell shape, hourglass shape, double trapezoidal shape, and H-shape, which is not specifically limited herein.

It should be noted that the above descriptions of the shape of the first solder joint W1a are only exemplary illustrations, and are not the only limitation or exclusive limitation on the specific structural form of the first solder joint W1a, as long as the aforementioned first size d1 is less than the second size d2.

Since the solder joint structure 130 is provided on the cell base 110, the solder strip 200 can achieve electrical connection with the finger 120 through alloying with the solder joint structure 130, and the finger 120 can transmit the collected current to the solder strip 200 through the solder joint structure 130 and output the current through the solder strip 200. By configuring the size of the middle portion W11 of the first solder joint W1a along the second direction F2 to be less than the size of the edge portion W12 along the second direction F2, the first solder joint W1a roughly forms a structure with wide ends and a narrow middle. Under such a structure, the connection strength between the solder strip 200 and the first solder joint W1a can be improved by the edge portion W12, the risk of separation between the middle portion W11 and the solder strip 200 can be reduced, and the risk of brittle fracture of the first solder joint W1a can be reduced by the middle portion W11.

According to some embodiments of the present application, a plurality of first solder joints W1a are provided in the target region z0, and the sizes of the middle portions W11 of the plurality of first solder joints W1a along the second direction F2 have at least two types. As shown in FIG. 1, such a configuration can be used for all target regions z0 or part of the target regions z0, which is not specifically limited herein.

Taking FIGS. 1 and 2 as examples, in the same target region z0, when the sizes of the middle portions W11 along the second direction F2 have two types, part of the middle portions W11 in the same target region z0 are defined as first middle portions W11a, and the other part of the middle portions W11 are defined as second middle portions W11b. The size of the first middle portion W11a along the second direction F2 is less than the size of the second middle portion W11b along the second direction F2.

FIG. 4 is a schematic view of the solder joint structures 130 in the same target region z0 according to other embodiments of the present application. FIG. 4 illustrates a case where the sizes of the middle portions W11 along the second direction F2 have three types in the same target region z0. In the same target area z0, part of the middle portions W11 are defined as first middle portions W11a, another part of the middle portions W11 are defined as second middle portions W11b, and the other part of the middle portions W11 are defined as third middle portions W11c. The size of the first middle portion W11a along the second direction F2 is less than the size of the second middle portion W11b along the second direction F2, and the size of the second middle portion W11b along the second direction F2 is less than the size of the third middle portion W11c along the third direction F3.

FIG. 5 is a schematic view of the solder joint structures 130 in the same target region z0 according to still other embodiments of the present application. FIG. 5 illustrates a case where the sizes of the middle portions W11 along the second direction F2 have six types in the same target region z0. Alternatively, in the same target region z0, the sizes of the middle portions W11 along the second direction F2 can also have other quantities, which are not specifically limited herein.

Due to the difference in the stress of different regions of the target area z0, the sizes of the middle portions W11 in the target region z0 along the second direction F2 are differentiated, which is conducive to controlling the stress risk of different regions, thereby improving the connection reliability of the solder strip 200. Compared to the case where the sizes of the middle portions W11 in the same target region z0 along the second direction F2 have one type, the case where the sizes of the middle portions W11 in the same target region z0 along the second direction F2 have at least two types is conducive to increasing the welding tensile force of the solder strip 200 through the middle portions W11 with larger sizes along the second direction F2, thereby further improving the connection reliability of the solder strip 200.

Therefore, in the embodiment of the present application, by configuring the first solder joint W1 and enabling the sizes of the middle portions W11 in at least one target region z0 along the second direction F2 have at least two types, the connection reliability of the solder strip 200 can be improved. Furthermore, according to the solar cell 100a provided by the embodiment of the present application, the adhesive dots used to fix the solder strip 200 can be omitted, which not only simplifies the production process but also reduces the reliability risk caused by the aging of adhesive dot.

Referring to FIGS. 2, 4 and 5, according to some embodiments of the present application, in at least one target region z0, two adjacent middle portions W11 along the second direction F2 have different sizes along the second direction F2. As shown in FIG. 1, such a configuration can be used for all target regions z0 or part of the target regions z0, which is not specifically limited herein.

Taking FIGS. 2 and 5 as examples, it illustrates that in the same target region z0, the sizes of any two adjacent middle portions W11 along the second direction F2 have different sizes along the second direction F2.

When the same solder strip 200 is subjected to thermal cycling or mechanical vibration, stress will be transmitted between adjacent solder joint structures 130 along a length direction of the solder strip 200. At this time, if at least one group of two adjacent middle portions W11 have different sizes along the second direction F2, the stress transmission path can be interrupted, thereby reducing the risk of stress superposition in a region between adjacent solder joint structures 130, improving mechanical impact resistance, and thus improving the connection stability and reliability of the solder strip 200.

Referring to FIG. 2, according to some embodiments of the present application, in at least one target region z0, the sizes of the middle portions W11 along the second direction F2 have two types, and two adjacent middle portions W11 have different sizes along the second direction F2. As shown in FIG. 1, such a configuration can be used for all target regions z0 or part of the target regions z0, which is not specifically limited herein.

Taking FIG. 2 as an example, along the second direction F2, the first middle portions W11a and the second middle portions W11b are alternately arranged.

Since the two middle portions W11 with different sizes are alternately arranged in at least one target region z0, a continuous structure for interrupting the stress transmission path can be constructed, thereby further improving the mechanical impact resistance, and thus further improving the connection stability and reliability of the solder strip 200. In addition, since the middle portions W11 of at least one target region z0 are regularly arranged, it is easier to manufacture and the process cost is reduced.

Referring to FIG. 5, according to some embodiments of the present application, along the second direction F2, from a center of the target region z0 to an edge of the target region z0, the sizes of the middle portions W11 increase sequentially along the second direction F2. That is, the closer to the center of the target region z0, the smaller the size of the middle portion W11 along the second direction F2, the closer to the edge of the target region z0, the larger the size of the middle portion W11 along the second direction F2. It should be undersood that the center of the target region z0 and the edge of the target region z0 are relative to the second direction F2.

In this way, the welding tensile force between the part closer to the edge of the solder strip 200 and the solder joint structure 130 is larger, which is beneficial to reducing the risk of the edge of the solder strip 200 separating from the cell base 110 due to stress.

Alternatively, in addition to the arrangement modes of the middle portions W11 of the first solder joint W1a shown in the above some embodiments, other arrangement modes, such as those shown in FIG. 4, may also be adopted, which is not specifically limited herein.

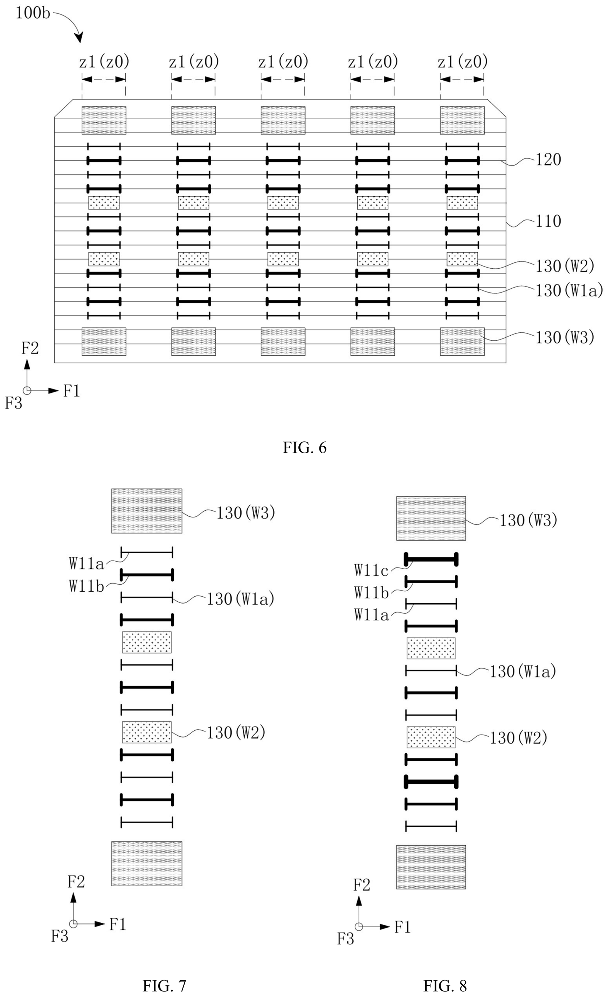

Referring to FIGS. 6 and 7, FIG. 6 is a schematic view of a solar cell 100b according to other embodiments of the present application, and FIG. 7 is a schematic view of the solder joint structures 130 in the same target region z0 according to still other embodiments of the present application. In at least one target region z0, the solder joint structure 130 further includes a second solder joint W2. The shape of the second solder joint W2 is different from that of the first solder joint W1, and an area of an orthographic projection of the first solder joint W1 on the cell base 110 is less than an area of an orthographic projection of the second solder joint W2 on the cell base 110. As shown in FIG. 6, such a configuration can be used for all target regions z0 or part of the target regions z0, which is not specifically limited herein.

In the target region z0 of the cell base 110, the plurality of solder joint structures 130 include the first solder joint W1a and the second solder joint W2. That is, both the first solder joint W1a and the second solder joint W2 are solder joint structures 130 on the target region z0, and the first solder joint W1a and the second solder joint W2 are solder joint structures 130 of different types. Depending on the different numbers of the first solder joints W1a and the second solder joints W2 in the target region z0, the connection reliability between the cell base 110 and the solder strip 200 can be improved through the different synergistic effects of the two. Taking FIGS. 6 and 7 as examples, the number of the first solder joints W1a in the target region z0 is greater than the number of the second solder joints W2. The first solder joint W1a can be used as a main solder joint, and the second solder joint W2 can be used as an auxiliary or enhanced functional solder joint. Thus, through the different shapes and sizes of the first solder joint W1a and the second solder joint W2, the differential connection between the first solder joint W1a, the second solder joint W2 and the solder strip 200 can be achieved.

By providing the larger second solder joint W2, the connection rigidity of the solder strip 200 can be improved. Therefore, through the cooperation of the first solder joint W1a and the second solder joint W2, not only the edge portion W12 of the first solder joint W1a and the second solder joint W2 can cooperate with each other to disperse stress and reduce the risk of stress concentration at the second solder joint W2, but also the first solder joint W1a and second solder joint W2 that are differentiated can be formed to adapt to multi-directional stress and reduce damage in a single direction, thereby improving the connection reliability of the solder strip 200 as a whole.

It should be understood that compared to a case that all the solder joint structures 130 are configured as the second solder joints W2, the embodiment of the present application not only can improve the reliability of the solder strip 200, but also can reduce the consumption of metal paste, thereby helping to control the manufacturing cost of the solar cell. Compared to a case that all the solder joint structures 130 are configured as the first solder joints W1a, the embodiment of the present application can further improve the connection reliability of the solder strip 200 through the second solder joint W2, and the second solder joint W2 and the first solder joint W1a can form differentiated stress resistances, thereby further improving the connection reliability of the solder strip 200.

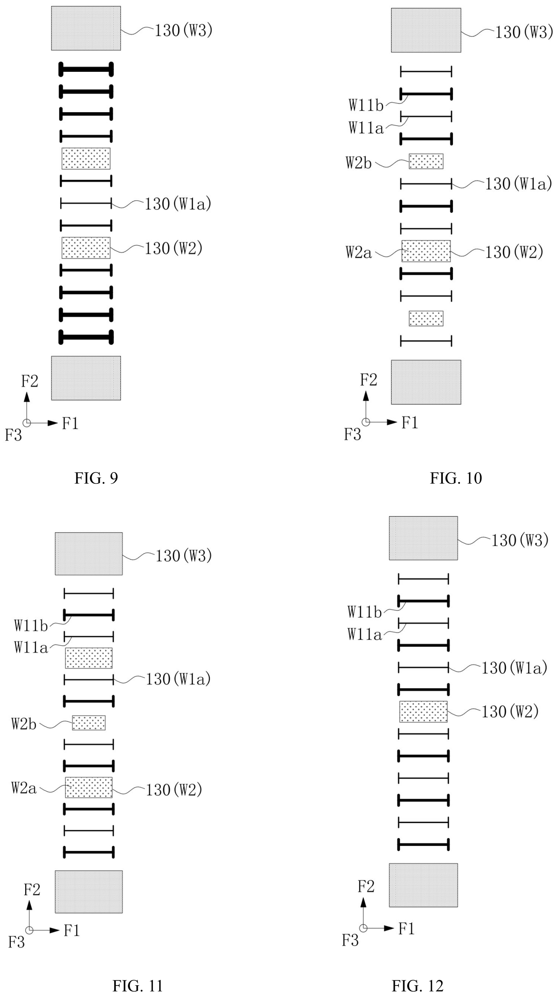

It should be noted that some embodiments of the first solder joint W1a shown in the aforementioned FIGS. 2, 4 and 5 can be freely combined with the second solder joint W2 to form different arrangement modes of the solder joint structures 130, such as those shown in FIGS. 7 to 9, which is not specifically limited herein. FIG. 8 is a schematic view of the solder joint structures 130 in the same target region according to yet other embodiments of the present application, and FIG. 9 is a schematic view of the solder joint structures in the same target region according to yet other embodiments of the present application.

Referring to FIG. 10, which is a schematic view of the solder joint structures 130 in the same target region z0 according to still further embodiments of the present application. A plurality of second solder joints W2 are provided on the target region z0. In the target region z0 provided with the plurality of second solder joints W2, areas of orthographic projections of the second solder joints W2 on the cell base 110 have at least two types. Such a configuration can be used for all target regions z0 or part of the target regions z0, which is not specifically limited herein.

Taking FIG. 10 as an example, in the same target region z0, the areas of the orthographic projections of the second solder joints W2 on the cell base 110 have two types, and the areas of the orthographic projections of at least one group of two adjacent second solder joints W2 along the second direction F2 on the cell base 110 are different. In this way, by providing the differentiated second solder joints W2, the difference between the solder joint structures 130 is utilized to form different degrees of tensile force with the solder strip 200, which is beneficial to resisting stress in different scenarios, thereby further improving the connection reliability of the solder strip 200.

Taking FIG. 10 as an example, in the same target region z0, the areas of the orthographic projections of any group of three adjacent second solder joints W2 along the second direction F2 on the cell base 110 are different. One of the second solder joints W2 is defined as a first type solder joint W2a, and the other two second solder joints W2 are defined as second type solder joints W2b. An area of an orthographic projection of the first type solder joint W2a on the cell base 110 is greater than an area of an orthographic projection of the second type solder joint W2b on the cell base 110.

It should be noted that the first solder joint W1a may or may not be provided between two adjacent second solder joints W2 along the second direction F2. Taking FIG. 10 as an example, along the second direction F2, the first solder joint W1a is provided between one group of two adjacent second solder joints W2, and the first solder joint W1a is also provided between another group of two adjacent second solder joints W2. Alternatively, referring to FIGS. 7 to 10, the second solder joint W2 may or may not be provided between two adjacent first solder joints W1a along the second direction F2, which is not specifically limited herein.

When the same solder strip 200 is in thermal cycle or subjected to mechanical vibration, stress will be transmitted between adjacent solder joint structures 130 along the length direction of the solder strip 200. At this time, when the areas of the orthographic projections of at least one group of two adjacent second solder joints W2 on the cell base 110 are different, the stress transmission path can be interrupted, thereby reducing the risk of stress superposition in the region between adjacent solder joint structures 130, improving the mechanical impact resistance, and thus improving the connection stability and reliability of the solder strip 200.

Referring to FIG. 11, which is a schematic view of the solder joint structures 130 in the same target region z0 according to yet other embodiments of the present application. The target region z0 includes a middle region and two edge regions located on both sides of the middle region along the second direction F2. In the target region z0, along the second direction F2, from the middle region to the edge regions, the area of the orthographic projection of the second solder joint W2 on the cell base 110 is gradually increased. Such a configuration can be used for all target regions z0 or part of the target regions z0, which is not specifically limited herein.

The gradually increasing means that the area of the orthographic projection may increase sequentially, increase first and then remain unchanged, or remain unchanged first and then increase, which is not specifically limited herein. Taking FIG. 11 as an example, in the same target region z0, along the second direction, from the middle region to the edge regions, the area of the orthographic projection of the second solder joint W2 on the cell base 110 increases sequentially. The second type solder joint W2b is located at the center of the target region z0, and the first type solder joint W2a is adjacent to the edge of the target region z0.

In this way, the welding tensile force between the part closer to the edge of the solder strip 200 and the solder joint structure 130 is larger, which is beneficial to reducing the risk of the edge of the solder strip 200 separating from the cell base 110 due to stress.

Referring to FIGS. 6 to 11, according to some embodiments of the present application, a plurality of the second solder joints W2 are provided on the target region z0. In the target region z0, at least one first solder joint W1a is provided between at least one group of two adjacent second solder joints W2 along the second direction F2. As shown in FIG. 6, such a configuration can be used for all target regions z0 or part of the target regions z0, which is not specifically limited herein.

In this way, when stress is transmitted between two adjacent second solder joints W2 along the second direction F2, the stress transmission path can be interrupted by the first solder joint W1a that is different from the second solder joint W2, thereby further reducing the risk of stress superposition in the region between adjacent solder joint structures 130, and further improving the connection stability and reliability of the solder strip 200.

Referring to FIGS. 6 to 11, according to some embodiments of the present application, in the target region z0, the first solder joints W1a are provided on both sides of the second solder joint W2 along the second direction F2. As shown in FIG. 6, such a configuration can be used for all target regions z0 or part of the target regions z0, which is not specifically limited herein.

In this way, since the first solder joints W1a are provided on both sides of the second solder joint W2 along the second direction F2, the difference between the first solder joint W1a and the second solder joint W2 can be utilized. When the same solder strip 200 is in thermal cycle or subjected to mechanical vibration, the stress transmission path can be further interrupted, thereby reducing the risk of stress superposition in the region between adjacent solder joint structures 130. In addition, the edge of the first solder joint W1a can cooperate with the first solder joint W1a to enhance the welding tensile force of the solder strip 200, thereby further improving the connection stability and reliability of the solder strip 200.

Referring to FIGS. 6 to 9, according to some embodiments of the present application, a plurality of the second solder joints W2 are provided on the target region z0. In the target region z0 provided with the plurality of second solder joints W2, the areas of the orthographic projections of the second solder joints W2 on the cell base 110 are equal. As shown in FIG. 6, such a configuration can be used for all target regions z0 or part of the target regions z0, which is not specifically limited herein.

In this way, since the areas of the orthographic projections of the second solder joints W2 on the cell base 110 are equal, the manufacture of the second solder joints W2 is facilitated.

Referring to FIGS. 6 to 9 and 11, according to some embodiments of the present application, a plurality of the second solder joints W2 are provided on at least one target region z0. In the target region z0 provided with the plurality of second solder joints W2, the plurality of second solder joints W2 are symmetric with respect to the center of the first region z1. As shown in FIG. 6, such a configuration can be used for all target regions z0 or part of the target regions z0, which is not specifically limited herein.

In this way, by symmetrically arranging the second solder joints W2, during thermal cycle, stress can be absorbed roughly synchronously, the risk of distortion of the solder strip 200 due to excessive stress on one side of the solder strip 200 is reduced, and the stress superposition between the solder joint structures 130 can also be reduced. In addition, the symmetrical arrangement of the second solder joints W2 can form a more balanced connection structure for the solder strip 200, thereby further improving the impact resistance and displacement resistance of the solder strip 200.

Referring to FIG. 12, which is a schematic view of the solder joint structures 130 in the same target region z0 according to still other embodiments of the present application. According to some embodiments of the present application, one second solder joint W2 is provided on at least one target region z0, and the second solder joint W2 is located in a middle region of the target region z0. Such a configuration can be used for all target regions z0 or part of the target regions z0, which is not specifically limited herein.

In this way, not only the welding tensile force between the middle portion W11 of the solder strip 200 and the solder joint structure 130 is increased, so that the overall expansion and contraction of the solder strip 200 can be suppressed by fixing the solder strip 200 at the center, but also the edge portions W12 of the solder strip 200 can buffer and disperse local stress through the first solder joint W1a. At the same time, with such a structure, the manufacture of the solder joint structure 130 is also facilitated.

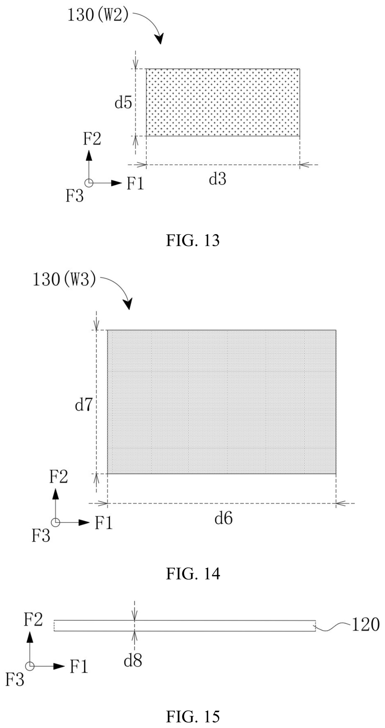

Referring to FIGS. 6 to 12 and in conjunction with FIG. 13, which is a schematic view of the second solder joint W2 in some embodiments of the present application. According to some embodiments of the present application, the shape of the orthographic projection of the second solder joint W2 on the cell base 110 is rectangular. According to other embodiments of the present application, the size of the second solder joint W2 along the first direction F1 is less than or equal to the size of the middle portion W11 along the first direction F1. According to still other embodiments of the present application, the size of the second solder joint W2 along the second direction F2 is greater than the size of the edge portion W12 along the second direction F2.

Taking FIGS. 3 and 13 as examples, the size of the second solder joint W2 along the first direction F1 is defined as a third size d3, the size of the middle portion W11 along the first direction F1 is defined as a fourth size d4, and d3 ≤ d4. The size of the second solder joint W2 along the second direction F2 is defined as a fifth size d5, the size of the edge portion W12 along the second direction F2 is defined as a second size d2, and d5 > d2.

In this way, since the shape of the orthographic projection of the second solder joint W2 on the cell base 110 is rectangular, it is not only beneficial to improving the fixing strength with the solder strip 200, but also facilitating the manufacture and connection of the solder strip 200. By controlling the size of the second solder joint W2 along the first direction F1 and/or the second direction F2, a solder joint structure 130 different from the first solder joint W1a can be formed between two adjacent first solder joints W1a, which is beneficial to controlling the size of the second solder joint W2, thereby increasing the welding tensile force of the solder strip 200 while reducing the consumption of metal paste.

Referring to FIGS. 1, 2, 6 to 12, according to some embodiments of the present application, an extending direction of a line connecting the centers of the solder joint structures 130 in at least one target region z0 is parallel to the second direction F2. As shown in FIGS. 1 and 6, such a configuration can be used for all target regions z0 or part of the target regions z0, which is not specifically limited herein.

In this way, it is not only beneficial to reducing the risk of distortion and stress concentration of the solder strip 200, but also facilitating the manufacture of the solder joint structures 130.

Referring to FIGS. 1, 2, 6 to 12, according to some embodiments of the present application, in at least one target region z0, along the second direction F2, the plurality of solder joint structures 130 include two third solder joints W3 located at both ends of the target region z0. An area of an orthographic projection of each third solder joint W3 on the cell base 110 is greater than the area of the orthographic projection of the second solder joint W2 on the cell base 110. As shown in FIGS. 1 and 6, such a configuration can be used for all target regions z0 or part of the target regions z0, which is not specifically limited herein.

In this way, by arranging the third solder joints W3 with greater orthographic projection areas at positions corresponding to both ends of the solder strip 200, the welding tensile force at both ends of the weld strip 200 can be further increased.

Referring to FIGS. 1, 2, 6 to 12, according to some embodiments of the present application, a ratio of the area of the orthographic projection of the second solder joint W2 on the cell base 110 to the area of the orthographic projection of the third solder joint W3 on the cell base 110 ranges from 0.35 to 0.5. According to other embodiments of the present application, the size of the second solder joint W2 along the first direction F1 is less than the size of the third solder joint W3 along the first direction F1, and the size of the second solder joint W2 along the second direction F2 is less than the size of the third solder joint W3 along the second direction F2. According to still other embodiments of the present application, the shape of the orthographic projection of the third solder joint W3 on the cell base 110 is rectangular.

Exemplarily, the ratio of the area of the orthographic projection of the second solder joint W2 on the cell base 110 to the area of the orthographic projection of the third solder joint W3 on the cell base 110 may be 0.35, 0.4, 0.45, 0.48 or 0.5. Alternatively, the ratio may be any value within the range of 0.35 to 0.5, which is not specifically limited herein.

Taking FIG. 13 as an example and in conjunction with FIG. 14, which is a schematic view of the third solder joint W3 in some embodiments of the present application. The size of the third solder joint W3 along the first direction F1 is defined as a sixth size d6, the size of the third solder joint W3 along the second direction F2 is defined as a seventh size d7, d6 > d3 and d7 > d5.

In this way, since the shape of the orthographic projection of the third solder joint W3 on the cell base 110 is rectangular, it is not only beneficial to improving the fixing strength with the solder strip 200, but also facilitating the manufacture and connection of the solder strip 200. By controlling the size of the third solder joint W3 along the first direction F1 and/or the second direction F2, a solder joint structure 130 different from the first solder joint W1a and the second solder joint W2 is formed, which is beneficial to controlling the size of the third solder joint W3, thereby increasing the welding tensile force of the solder strip 200 while reducing the consumption of metal paste.

Referring to FIGS. 6 and 7, according to some embodiments of the present application, two second solder joints W2 are provided on at least one target region z0, and the two second solder joints W2 are symmetric with respect to the center of the target region z0. As shown in FIG. 6, such a configuration can be used for all target regions z0 or part of the target regions z0, which is not specifically limited herein.

In this way, by providing the second solder joint W2 and the third solder joint W3, the welding tensile force at both ends of the solder strip 200 and the middle portion of the solder strip 200 is further increased, thereby improving the connection reliability of the solder strip 200. With such a structure, the solder strip 200 is constrained in sections, and cooperates with the first solder joint W1a, which not only can control the shape of the solder strip 200 and improve the connection stability of the solder strip 200, but also is beneficial to improving the connection reliability of the solder strip 200.

Referring to FIG. 3, according to some embodiments of the present application, a direction in which a starting end of the middle portion W11 points to a terminal end of the middle portion W11 is parallel to the first direction F1. According to other embodiments of the present application, the size of the middle portion W11 along the second direction F2 is greater than the size of the finger 120 along the second direction F2.

Taking FIGS. 3 and 15 as examples, FIG. 15 is a schematic view of a portion of the finger 120 according to some embodiments of the present application. The size of the finger 120 along the second direction F2 is defined as an eighth size d8, and d1 > d8.

In this way, by controlling the approximate extending shape of the middle portion W11 and/or the size of the middle portion W11 along the second direction F2, it is advantageous for the middle portion W11 to be connected to the finger 120 while also facilitating the connection of the middle portion W11 to the solder strip 200. In addition, since the size of the edge portion W12 along the second direction F2 is greater than the size of the middle portion W11 along the second direction F2, the reliability of the connection between the finger 120 and the first solder joint W1a can be improved by utilizing the edge portion W12, which facilitates the connection between the first solder joint W1a and the finger 120.

Referring to FIGS. 3 and 15, according to some embodiments of the present application, along the second direction F2, the ratio of the size of the middle portion W11 F2 to the size of the finger 120 ranges from 3 to 6. According to other embodiments of the present application, the size of the middle portion W11 along the second direction F2 ranges from 40 µm to 55 µm.

Taking FIGS. 3 and 15 as examples, the ratio of the first size d1 to the eighth size d8 is 3, 3.5, 4, 4.5, 5, 5.5 or 6. Alternatively, the ratio of the first size d1 to the eighth size d8 may be any value within the range of 3 to 6, which is not specifically limited herein.

Taking FIG. 3 as an example, the first size d1 may be 40 µm, 42 µm, 45 µm, 46 µm, 48 µm, 50 µm, 52 µm, 53 µm or 55 µm. Alternatively, the first size d1 may be any value within the range of 40 µm to 55 µm, which is not specifically limited herein.

In this way, by controlling the size relationship between the middle portion W11 and the finger 120 and/or the size of the middle portion W11 along the second direction F2, the connection with the finger 120 and the solder strip 200 is facilitated while saving the metal paste.

Referring to FIG. 3, according to some embodiments of the present application, the edge portion W12 extends along the second direction F2. In this way, a process window for manufacturing the first solder joint W1a and the finger 120 can be improved, which is beneficial to the connection between the edge portion W12 and the finger 120, as well as the connection between the first solder joint W1a and the solder strip 200.

According to some embodiments of the present application, a connection region is defined at a junction of the edge portion W12 and the middle portion W11, and the edge portions W12 are symmetrically arranged with respect to the connection region.

In this way, it is convenient to connect the edge portion W12 with the finger 120 and manufacture the edge portion W12.

Referring to FIG. 3, according to some embodiments of the present application, the second size d2 of the edge portion W12 along the second direction F2 ranges from 0.1 mm to 0.3 mm.

Exemplarily, the second size d2 is 0.1 mm, 0.12 mm, 0.15 mm, 0.2 mm, 0.24 mm, 0.28 mm or 0.3 mm. Alternatively, the second size d2 may be any value within the range of 0.1 mm to 0.3 mm, which is not specifically limited herein.

In this way, by controlling the size of the edge portion W12, the connection with the finger 120 and the solder strip 200 is facilitated while saving the metal paste.

Referring to FIGS. 1 to 12, according to some embodiments of the present application, the middle portion W11 extends linearly from the starting end to the terminal end.

In this way, since the middle portion W11 extends linearly, it is not only beneficial to manufacture, but also beneficial to improving the stability of the connection between the middle portion W11 and the solder strip 200 and facilitating more uniform stress distribution.

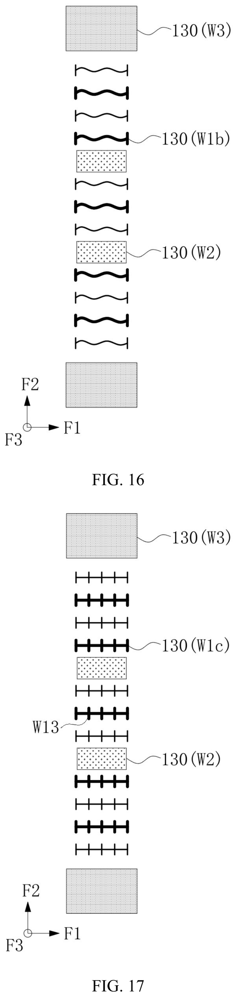

Referring to FIG. 16, which is a schematic view of the solder joint structures 130 in the same target region z0 according to still another embodiments of the present application. According to some embodiments of the present application, the middle portion W11 extends in a curve shape from the starting end to the terminal end. In this way, a first solder joint W1b different from the first solder joint W1a illustrated above is formed. It should be noted that the position of the middle portion of the first solder joint W1b can be understood with reference to the position of the middle portion W11 of the first solder joint W1a shown in FIG. 3. The difference is that the middle portion of the first solder joint W1b and the middle portion W11 of the first solder joint W1a have different shapes.

In this way, since the middle portion extends in a curve shape, not only the contact area with the solder strip 200 can be increased, but also more stress release spaces can be formed by using the curve middle portion, thereby further improving the connection stability and reliability of the solder strip 200.

Referring to FIG. 17, which is a schematic view of the solder joint structures 130 in the same target region z0 according to yet other embodiments of the present application. According to some embodiments of the present application, the first solder joint W1c further includes at least one reinforcing portion W13 provided in the middle region of the middle portion W11. It should be noted that the position of the middle portion of the first solder joint W1c can be understood with reference to the position of the middle portion W11 of the first solder joint W1a shown in FIG. 3. The difference is that no reinforcing portion W13 is provided on the middle portion W11 of the first solder joint W1a shown in FIG. 3.

The structure and arrangement mode of the reinforcing portion W13 can refer to the edge portion W12 illustrated above, and will not be repeated here. The difference between the reinforcing portion W13 and the edge portion W12 is that the reinforcing portion W13 is located in the middle region of the middle portion W11. Taking FIG. 17 as an example, the first solder joint W1c includes a plurality of reinforcing portions W13 that are spaced apart along the first direction F1.

It should be understood that the reinforcing portion W13 can increase a contact area between the first solder joint W1c and the solder strip 200, thereby improving the connection performance between the first solder joint W1c and the solder strip 200. In this way, by providing the reinforcing portion W13, the connection performance of the solder strip 200 can be further improved.

In some embodiments, the plurality of reinforcing portions W13 of the first solder joint W1c on the same target region z0 may be arranged in a staggered manner along the second direction F2. In this way, the difference between each part of the solder joint structure 130 can be further utilized to improve the connection stability and reliability of the solder strip 200.

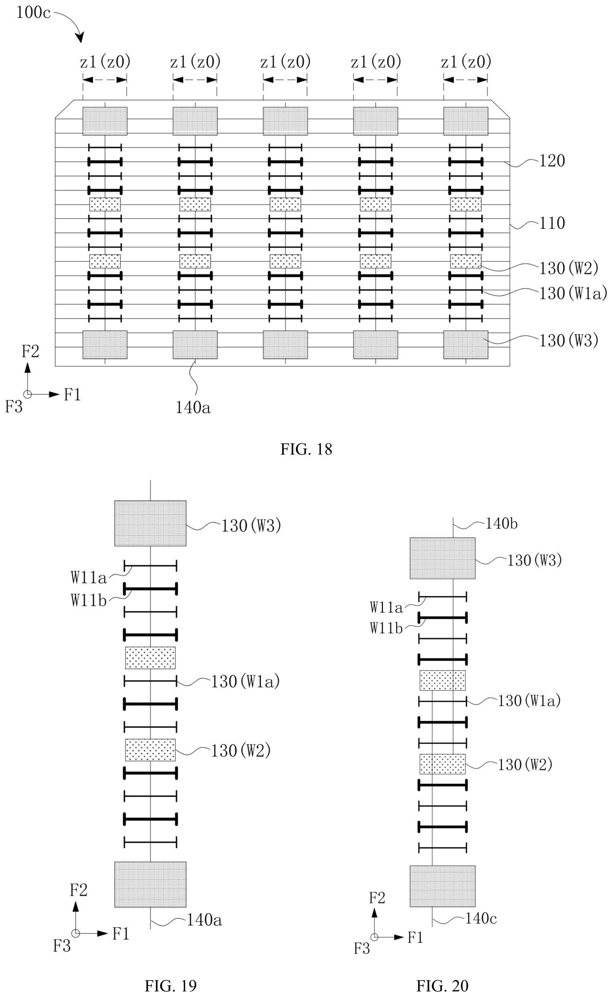

Referring to FIGS. 18 and 19, FIG. 18 is a schematic view of a solar cell 100c according to still other embodiments of the present application, and FIG. 19 is a schematic view of the solder joint structures 130 in the same target region z0 according to still other embodiments of the present application. According to some embodiments of the present application, the solar cell 100c further includes at least one connecting line 140a. In the target region z0, the at least one connecting line 140a is connected to at least part of the solder joint structures 130. As shown in FIG. 18, such a configuration can be used for all target regions z0 or part of the target regions z0, which is not specifically limited herein.

FIG. 19 shows a case where one connecting line 140a connected to all the solder joint structures 130 is provided in the same target region z0. Taking FIG. 20 as an example, FIG. 20 is a schematic view of the solder joint structures 130 in the same target region z0 according to yet other embodiments of the present application. According to some embodiments of the present application, the solar cell 100c further includes a connecting line 140b and a connecting line 140c, the connecting line 140b is connected to part of the solder joint structures 130, and the connecting line 140c is connected to the other part of the solder joint structures 130, which is not specifically limited herein.

Taking FIGS. 19 and 20 as examples, the connecting line 140a, the connecting line 140b, and the connecting line 140c all extend linearly along the second direction F2. Alternatively, the connecting line 140a may also be configured in a curve shape, which is not specifically limited herein.

In this way, by providing the connecting lines, the welding tensile force of the solder strip 200 can be further improved, as well as the reliability of the connection between each solder joint structure 130 and the solder strip 200 can be improved, thereby further improving the reliability of the connection of the solder strip 200.

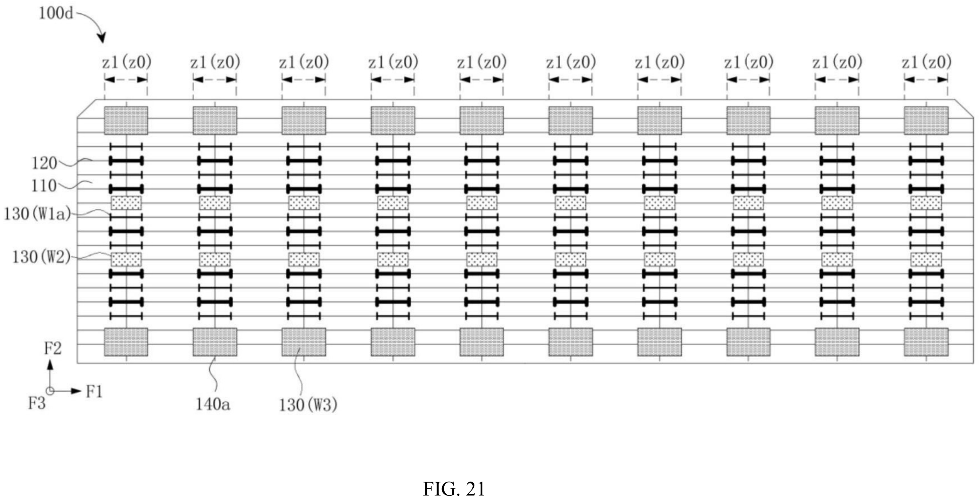

It should be noted that the number of connecting lines is related to the number of target regions z0. The number of target regions z0 may be 10 to 20, and the number of connecting lines may be 10 to 20. FIG. 21 is a schematic view of a solar cell 100d according to still further embodiments of the present application. Taking FIG. 21 as an example, the number of target regions z0 is 10, and the number of connecting lines 140a is also 10. Alternatively, when a plurality of connecting lines 140a are provided on one target region z0, the number of connecting lines 140a may also be greater than the number of target regions z0, which is not specifically limited herein. In addition, in some of the aforementioned embodiments where no connecting lines are shown, connecting lines may also be provided with reference to the above illustrations, which is not specifically limited herein.

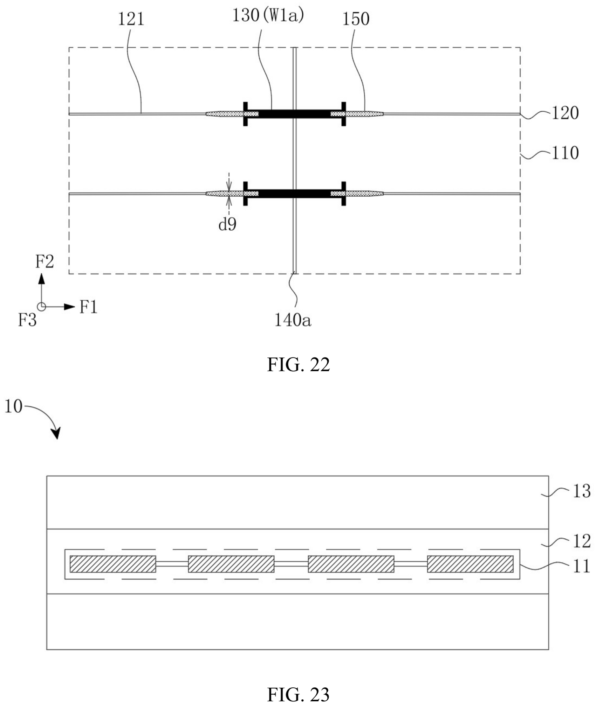

Referring to FIG. 22, which is a schematic view of a partial structure of a solar cell according to yet other embodiments of the present application. According to some embodiments of the present application, the finger 120 connected to the first solder joint W1a includes a plurality of sub-fingers 121 spaced apart along the first direction F1, and the solar cell further includes a plurality of transition connection portions 150. Adjacent two sub-fingers 121 along the first direction F1 are respectively connected to both ends of the first solder joint W1a along the first direction F1 in a one-to-one correspondence through one transition connection portion 150.

In this way, by configuring the finger 120 as the plurality of sub-fingers 121 and connecting the sub-fingers 121 and the corresponding first solder joints W1a using the transition connection portion 150, not only the connection between the sub-fingers 121 and the corresponding first solder joints W1a can be realized, but also the risk of grid breakage of the sub-fingers 121 can be reduced.

Alternatively, in other embodiments, the plurality of sub-grid lines included in the finger 120 may be directly connected, which is not specifically limited herein.

Referring to FIG. 22, according to some embodiments of the present application, along the direction in which one end of the transition connection portion 150 connected to the first solder joint W1a points to the other end of the transition connection portion 150 connected to the sub-finger 121, the size of the transition connection portion 150 along the second direction F2 is gradually decreased.

The gradually decreasing means that the size may decrease first and then remain unchanged, or decrease continuously, or remain unchanged first and then decrease. Taking FIG. 22 as an example, along the direction in which one end of the transition connection portion 150 connected to the first solder joint W1a points to the other end of the transition connection portion 150 connected to the sub-finger 121, the size of the transition connection portion 150 along the second direction F2 first remains unchanged and then decreases. The size of the transition connection portion 150 along the second direction F2 is defined as a ninth size d9 shown in FIG. 22.

In this way, by controlling the size of the transition connection portion 150 along the second direction F2, the transition connection portion 150 is connected between the sub-finger 121 and the first solder joint W1a in a transitional manner, thereby further reducing the risk of grid breakage of the sub-finger 121 while saving the metal paste for manufacturing the transition connection portion 150.

According to some embodiments of the present application, the cell base 110 includes a front side and a back side that are opposite to each other, the fingers 120 are provided on both the front side and the back side, and at least the back side is provided with the target region z0 and the solder joint structures 130.

Since the back side of the cell base 110 has a high reliability risk, providing the target region z0 and the solder joint structures 130 on the back side is beneficial to improving the connection reliability of the solder strip 200.

Therefore, based on the situations illustrated in the above some embodiments, the examples of the solder joint structure 130 in the embodiments of the present application are exemplarily described, but are not limited thereto.

In Example 1, taking FIGS. 6 and 7 as examples, the middle portion W11 extends longitudinally along the first direction F1, the edge portions W12 extend longitudinally along the second direction F2, and the edge portions W12 are symmetrically arranged with respect to the middle portion W11. The size of the edge portions W12 along the second direction F2 ranges from 0.1 mm to 0.3 mm, the size of the first middle portion W11a along the second direction F2 is 40 µm, and the size of the second middle portion W11b along the second direction F2 is 55 µm. The first middle portions W11a and the second middle portions W11b are alternately arranged along the second direction F2. The shape of the orthographic projection of the second solder joint W2 on the cell base 110 is rectangular, and two second solder joints W2 are provided. The two second solder joints W2 are symmetrically arranged with respect to the center of the target region z0, and the first solder joints W1a are provided on both sides of the second solder joint W2 along the second direction F2. The distance between the two second solder joints W2 along the second direction F2 ranges from 14 mm to 15 mm. The size of the second solder joint W2 along the first direction F1 is 0.7 mm, and the size of the second solder joint W2 along the second direction F2 is 0.3 mm. The shape of the orthographic projection of the third solder joint W3 on the cell base 110 is rectangular, the size of the third solder joint W3 along the first direction F1 is 1 mm, and the size of the third solder joint W3 along the second direction F2 is 0.6 mm.

In Example 2, taking FIG. 12 as an example, different from Example 1, one second solder joint W2 is provided and located at the center of the target region z0.

In Example 3, taking FIG. 12 as an example, different from Example 2, the size of the second middle portion W11b along the second direction F2 is 50 µm.

In Example 4, the solder joint structure 130 as shown in FIG. 2 is provided on the target region z0 of the front side of the cell base 110, and the solder joint structure 130 as shown in FIG. 7 is provided on the target region z0 of the back side of the cell base 110. The implementation of the solder joint structure 130 shown in FIG. 7 can refer to Example 1.

In Example 5, taking FIG. 19 as an example, different from Example 1, a connecting line 140a connecting all the solder joint structures 130 on the target region z0 is provided.

In Example 6, taking FIG. 1 as an example, different from Example 2, no second solder joint W2 is provided.

It should be noted that the finger 120, the solder joint structure 130, the connecting line 140a, and the connecting portion in the embodiments of the present application can all be formed on the cell base 110 by printing metal paste. The finger 120, the solder joint structure 130, the connecting line 140a, and the connecting portion can be printed simultaneously through the same printing screen, or separately printed through different printing screens, which is not specifically limited herein. It should be understood that the screen patterns on the printing screen are respectively adapted to the finger 120 to be printed, the solder joint structure 130, the connecting line 140a and the connecting portion.

When a plurality of target regions z0 are provided, the solder joint structures 130 provided on the plurality of target regions z0 may be the same or different. In the embodiments as shown in FIGS. 1, 6, 18 and 21, the solder joint structures 130 provided on all target regions z0 are the same. It should be understood that when the solder joint structures 130 provided on the plurality of target regions z0 are different, different solder joint structures 130 can be configured more flexibly according to different portions of the cell base 110, thereby improving the reliability of the overall structure.

Referring to FIG. 23, which is a schematic view of a photovoltaic module 10 according to some embodiments of the present application. An embodiment of the present application provides a photovoltaic module 10, which includes the solar cell according to any one of the above embodiments and a solder strip 200. The solder strip 200 is connected to the solder joint structures 130 and covers at least part of the solder joint structure 130.

Exemplarily, the photovoltaic module 10 includes a cover plate 13, an encapsulation layer 12, and a cell string 11, and the cover plate 13 is connected to the cell string 11 through the encapsulation layer 12. The cell string 11 includes a plurality of solar cells according to any one of the above embodiments and a solder strip 200, and the plurality of solar cells are connected through the solder strip 200. The encapsulation layer 12 is configured to cover a surface of the cell string 11. The cover plate 13 is configured to cover a surface of the encapsulation layer 12 away from the cell string 11.

Exemplarily, the encapsulation layer 12 may be an organic encapsulation film such as an ethylene-vinyl acetate copolymer (EVA) film, a polyethylene octene copolymer elastomer (POE) film, or a polyethylene terephthalate (PET) film.

Exemplarily, the cover plate 13 may be a glass cover plate, a plastic cover plate, or other cover plates with light transmission function.

For example, each solar cell may be a whole cell or a split cell that is 1/N of the whole cell, which is not specifically limited herein. For example, when the solar cell is a split cell that is 1/4 of the whole cell, the aforementioned implementation with the third solder joint W3 is also beneficial to providing a jumper layer and reducing the risk of false welding caused by providing the jumper layer.

Exemplarily, the type of the solar cell is a zero busbar (0BB) cell. By completely removing the front busbar, the front side of the solar cell can be fully exposed to sunlight to maximize the light absorption area, thereby helping to reduce optical loss and improve short-circuit current. At the same time, by retaining the finger and the back electrode, the solar cell has high photoelectric conversion efficiency and low production cost.

The photovoltaic module 10 also has the advantages of the solar cells mentioned above, which will not be repeated here.

## Claims

1. A solar cell, comprising:
a cell base (110) defining a plurality of first regions (z1) arranged along a first direction (F1),
at least one of the plurality of first regions (z1) being a target region (z0);
a plurality of fingers (120) spaced apart along a second direction (F2); and
a plurality of solder joint structures (130) connected to one of the plurality of fingers (120), the plurality of solder joint structures (130) being located in the target region (z0) and arranged along the second direction (F2), the plurality of solder joint structures (130) comprising a first solder joint (W1a), the first solder joint (W1a) comprising a middle portion (W11) and edge portions (W12) provided at both ends of the middle portion (W11) along the first direction (F1), and a size of the middle portion (W11) along the second direction (F2) being less than a size of the edge portion (W12) along the second direction (F2).

2. The solar cell according to claim 1, wherein the plurality of solder joint structures (130) comprise a plurality of first solder joints (W1a), and in the target region (z0), two middle portions (W11) of two adjacent first solder joints (W1a) along the second direction (F2) have different sizes along the second direction (F2).

3. The solar cell according to claim 1 or 2, wherein a direction in which a starting end of the middle portion (W11) points to a terminal end of the middle portion (W11) is parallel to the first direction (F1); or the size of the middle portion (W11) along the second direction (F2) is greater than a size of the finger (120) along the second direction (F2);
optionally, wherein along the second direction (F2), a ratio of the size of the middle portion (W11) to the size of the finger (120) ranges from 3 to 6;or the size of the middle portion (W11) along the second direction (F2) ranges from 40 µm to 55 µm.

4. The solar cell according to any one of claims 1 to 3, wherein the edge portion (W12) extends along the second direction (F2), a connection region is defined at a junction of the edge portion (W12) and the middle portion (W11), and the edge portion (W12) is symmetrically arranged with respect to the connection region;
optionally, wherein the size of the edge portion (W12) along the second direction (F2) ranges from 0.1 mm to 0.3 mm.

5. The solar cell according to claim 3, wherein the middle portion (W11) extends linearly or in a curve shape from the starting end to the terminal end.

6. The solar cell according to any one of claims 1 to 5, wherein the plurality of solder joint structures (130) comprise a second solder joint (W2), a shape of the second solder joint (W2) is different from a shape of the first solder joint (W1a), and an area of an orthographic projection of the first solder joint (W1a) on the cell base (110) is less than an area of an orthographic projection of the second solder joint (W2) on the cell base (110).

7. The solar cell according to claim 6, wherein the plurality of solder joint structures (130) comprise a plurality of second solder joints (W2), and areas of two adjacent second solder joints (W2) along the second direction (F2) are different.

8. The solar cell according to claim 7, wherein the target region (z0) comprises a middle region and edge regions located on both sides of the middle region along the second direction (F2), from the middle region to the edge regions, areas of orthographic projections of the plurality of second solder joints (W2) on the cell base (110) are gradually increased.

9. The solar cell according to claim 7, wherein at least one first solder joint (W1a) is provided between two adjacent second solder joints (W2) along the second direction (F2), or the first solder joint (W1a) is provided on each of both sides of the second solder joint (W2) along the second direction (F2).

10. The solar cell according to claim 6, wherein the plurality of solder joint structures (130) comprise a plurality of second solder joints (W2), and areas of orthographic projections of the plurality of second solder joints (W2) on the cell base (110) are equal;
or, wherein the plurality of second solder joints (W2) are symmetric with respect to a center of the target region (z0),
or, wherein the plurality of second solder joints (W2) are located in a middle region of the target region (z0).

11. The solar cell according to claim 6, wherein the orthographic projection of the second solder joint (W2) on the cell base (110) is rectangular; or wherein a size of the second solder joint (W2) along the first direction (F1) is less than or equal to the size of the middle portion (W11) along the first direction (F1);or wherein a size of the second solder joint (W2) along the first direction (F1) is greater than a size of the second solder joint (W2) along the second direction (F2).

12. The solar cell according to claim 6, wherein the plurality of solder joint structures (130) comprise two third solder joints (W3) located at both ends of the target region (z0) along the second direction (F2), respectively, an area of an orthographic projection of each third solder joint (W3) on the cell base (110) is greater than the area of the orthographic projection of the second solder joint (W2) on the cell base (110);
optionally, wherein a ratio of the area of the orthographic projection of the second solder joint (W2) on the cell base (110) to the area of the orthographic projection of the third solder joint (W3) on the cell base (110) ranges from 0.35 to 0.5;
or, wherein a size of the second solder joint (W2) along the first direction (F1) is less than a size of the third solder joint (W3) along the first direction (F1), and a size of the second solder joint (W2) along the second direction (F2) is less than a size of the third solder joint (W3) along the second direction (F2);
or, wherein a shape of the orthographic projection of the third solder joint (W3) on the cell base (110) is rectangular.

13. The solar cell according to any one of claims 1 to 12, further comprising a connecting line (140a), wherein in the target region (z0), the connecting line (140a) connects at least part of the plurality of solder joint structures (130).

14. The solar cell according to any one of claims 1 to 13, further comprising a plurality of transition connection portions (150), wherein the finger (120) connected to the first solder joint (W1a) comprises a plurality of sub-fingers (121) spaced apart along the first direction (F1), and adjacent two sub-fingers (121) along the first direction (F1) are respectively connected to both ends of the first solder joint (W1a) along the first direction (F1) in a one-to-one correspondence through two transition connection portions (150);
optionally, wherein along the direction in which one end of the transition connection portion (150) connected to the first solder joint (W1a) points to another end of the transition connection portion (150) connected to the sub-finger (121), a size of the transition connection portion (150) along the second direction (F2) is gradually decreased.

15. A photovoltaic module (10), comprising the solar cell according to any one of claims 1 to 14 and a solder strip (200), the solder strip (200) being connected to a plurality of solder joint structures (130) and covering at least part of the plurality of solder joint structures (130).
